# EUROPEAN PATENT APPLICATION

(11) **EP 4 672 330 A1**
(43) Date of publication of application: **31.12.2025**
(21) Application number: 24184736.7
(22) Date of filing: 26.06.2024
(51) Int. Cl.: H01L 23/495

(54) **A SEMICONDUCTOR DEVICE AND A METHOD OF MANUFACTURING OF THE SEMICONDUCTOR DEVICE**

(71) Applicant: Nexperia B.V., 6534 AB Nijmegen (NL)
(72) Inventor: Ramalingam, Vegneswary, Seremban (MY); Shiu, Heiming, Hamburg (DE); Syré, Jörg, Hamburg (DE); Wong, Fei, Manchester (GB)
(74) Representative: Pjanovic, Ilija

(57) **Abstract**

According to a first example of the disclosure a semiconductor device is proposed, comprising a die constituting the top layer of the semiconductor device, preferably made of silicone; a lead frame constituting the bottom layer of the semiconductor device, having high electrical conductivity in the range between 6.3×10⁷ Siemens to 1×10⁶ Siemens more preferably 1×10⁷ Siemens (electrical conductivity is normally measured in Siemens per meter S/m, range of conductivity for Cu alloy lead frames are between 5 to 6×10⁷ S/m) for example made of L/F C19210 material; a first layer formed from a metallic foam located between the lead frame and the die, with a thickness preferably in the range of 500 nm to 5000 nm more preferably 2000nm, and with a porosity in range of 30% and 90% preferably 60% and a second layer located between the die and the lead frame being only partially in surface contact with the first layer.

## Description

### TECHNICAL FIELD

The present disclosure relates to a semiconductor device and to a method of manufacturing the semiconductor device.

### BACKGROUND OF THE DISCLOSURE

A silicone die is a crystal with a different directional thermal expansion coefficient. It requires careful connection so that the layers in between can expand accordingly and prevent the cracks during cooling.

The solution described in American patent US2018158757 describes a method which involves electrically contacting a component with at least one electrical contact by galvanically connecting it to at least one open-pored contact piece, which may be made of porous material or metal and can have various structures like tissue-like or mesh-like. The connection process is conducted at temperatures not exceeding 100 °C and can be achieved through electrochemical plating or methods free of external current. The component can be connected to other components, current conductors, or substrates, and the contact pieces may be coated with an electrical insulation layer. This method is applicable to power components and components with transistors, potentially involving contacts on opposite sides of the component. A component module formed this way includes a component with at least one electrical contact connected to at least one open-pored contact piece.

In general solid Aluminum layer is known stress reliever metal layer commonly used as one of the layers that connect the die with the lead frame. Lateral die cracks occur when Aluminum is removed from Ti/NiV/CuSn connection. Study shows that a minimal thickness of 1.5 µm AI is needed to allow proper stress relaxation on small die, however thicker AI may be needed to cater larger die. Usage of thicker AI > 1.5µm layers requires costly process, however it is necessary to prevent the crack formation and to control metal burr creation. Hence no universal solution to tackle stress accumulation for all die size with a reasonable cost is available. There exists a need to overcome the disadvantages associated with existing methods of connecting the die and lead frame for semiconductor assemblies of all sizes.

Accordingly, it is a goal of the present disclosure to provide an improved semiconductor device, such as a transistor. The semiconductor device comprises a die and a lead frame connected by a number of layers in between.

### SUMMARY OF THE DISCLOSURE

According to a first example of the disclosure a semiconductor device is proposed, comprising:
a die constituting the top layer of the semiconductor device, preferably made of silicone;
a lead frame constituting the bottom layer of the semiconductor device, having high electrical conductivity in the range between 6.3×10⁷ Siemens to 1×10⁶ Siemens more preferably 1×10⁷ Siemens (electrical conductivity is normally measured in Siemens per meter S/m, range of conductivity for Cu alloy lead frames are between 5 to 6×10⁷ S/m) for example made of L/F C19210 material;
a first layer formed from a metallic foam located between the lead frame and the die, with a thickness preferably in the range of 500 nm to 5000 nm more preferably 2000nm, and with a porosity in range of 30% and 90% preferably 60%; and
a second layer located between the die and the lead frame being only partially in surface contact with the first layer.

At least part of the second layer is interpenetrated with the first layer through the pores of the foam of the first layer. This in turn creates an intermediate layer, which allows to increase the surface area of contact between first and second layer, connecting them both mechanically and electrically. Additionally since only part of the foam of the first layer would be interpenetrated by the second layer it allows to alleviate stress problems replacing the solid Aluminum layer as the stress reliever, as well as reduce dicing problems caused by usage of solid Aluminum layers thicker than 1500nm, while at the same time allowing great thermal electrical and mechanical contact between the layers.

The semiconductor device may additionally comprise at least one, third layer located between the die and the lead frame, which comprises metals chosen from the group Titanium, Nickel, Vanad, Aluminum, Magnesium, Copper, Wolfram, or the alloys of mentioned materials. For example, the semiconductor device may comprise an additional third layer of 100nm of Titanium and 250nm layer of Nickel Vanadium.

According to another embodiment the semiconductor device may comprise an additional third layers 3 made of 100 nm of Titanium, 250 nm layer of Nickel Vanadium, 500nm layer of Copper, 2000nm layer of Tin and two intermediate layers of Cu3Sn and Cu6Sn5 in the area of contact of Tin and Copper layers.

The first layer may be also made of Aluminum foam or its alloys, in such case the second layer should be made of Nickel, Vanadium or its alloys. When using Aluminum foam as the first layer the third layers 3 of Copper and Tin in surface contact with each other can be used wherein on top and bottom of the Tin layer there is second intermediate layer made of Copper and Tin alloys.

The first layer may be also made of Copper foam or its alloys, in such case the second layer should be made of Tin or its alloys. When using Copper foam as the first layer the alloy is created in the areas of contact namely Cu6Sn5 and Cu3Sn referred as first intermediate layer. In case of using Copper as the first layer and Tin as second layer there is no need for any Aluminum layers.

According to another aspect of the disclosure a method of manufacturing the semiconductor device is provided comprising the following steps:
a) providing a lead frame constituting the top layer of semiconductor device;
b) providing a die constituting the bottom layer of semiconductor device;
c) providing first layer between the lead frame and the die;
d) providing second layer between the lead frame and the die, being only partially in surface contact with the first layer;
e) heating at least the second layer to the temperature of at least its melting point and lower then first layer melting point to secure first layer meta foam structure, allowing the second layer to interpenetrate at least part of the first layer through the pores of the foam of the first layer and creating the first intermediate layer between first layer and second layer.

An additional step of providing the at least one third layer between the lead frame and the die can be performed. The third layer being in surface contact with two of the layers: lead frame, die, first layer, second layer or different third layer. For example, a semiconductor device can have a configuration which is structured as follows: the die, 100nm of Titanium layer, 250nm of Nickel Vanadium layer, 2000nm of foam Copper, 1000nm of Tin and lead frame.

In summary, the advantages of the disclosure are improved conductivity, improved mechanical connection, providing alternative to expensive solid aluminum layer commonly used as a stress relaxation layer with a metal foam layer that is cheaper and reduces or alleviates the burr during dicing caused by thick Aluminum layer while maintaining the function of stress relaxation.

### BRIEF DESCRIPTION OF THE DRAWINGS

The disclosure will now be discussed with reference to the drawings, wherein:
Figure 1 illustrates comparison of attachment of die to the lead frame between the prior art and the proposed solution according to the first embodiment of the disclosure;
Figure 2 illustrates comparison of attachment of die to the lead frame between the prior art and the proposed solution according to the second embodiment of the disclosure.

### DETAILED DESCRIPTION OF THE DISCLOSURE

For a proper understanding of the disclosure, in the detailed description below corresponding elements or parts of the disclosure will be denoted with identical reference numerals in the drawings.

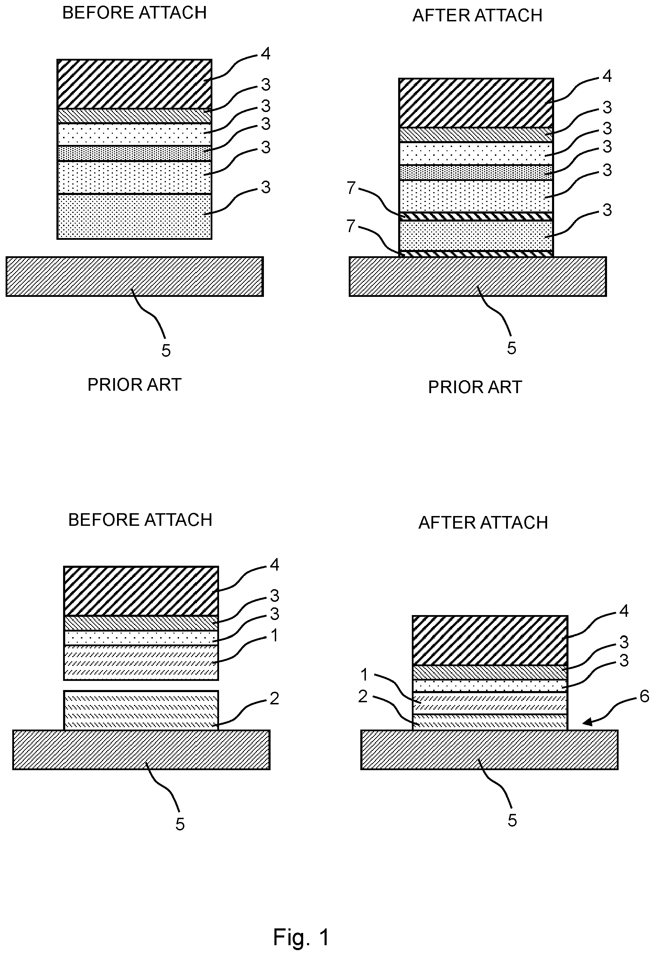

Figure 1 shows a comparison of a prior art method (on top) and the solution described by this document (on the bottom). The lead frame 5 serves as a base of the semiconductor device to which the die 4 can be attached. The lead frame 5 is preferably made of L/F C19210 and have thickness of 0.25 mm, however this is not limiting factor as any person skilled in art would be able to determine other materials and thicknesses that could be used for the lead frame 5. The die 4 is secured to a portion of the lead frame 5 designated for attachment. The die 4 is attached to the lead frame 5 by series of layers stacked on top of each other. The die 4 is made of semiconducting material for example silicone. The die 4 can have a functional circuit fabricated thereon. The die 4 is generally rectangular but may be any other suitable shape.

The series of layers are used to connect the die 4 to the lead frame 5 this may be done only by using first layer 1 comprising foam metal material for example copper foam or aluminum foil and second layer 2 made of Tin or Nickel Vanadium. There may be used additional layers called third layer 3 in between the lead frame 5 and the die 4 which can comprise variety of metals such as: Titanium, Nickel, Vanad, Aluminum, Magnesium, Copper, Wolfram or its alloys. The layers can have various thicknesses in ranges between 50 to 5000 nm. Such modification allows to completely remove the aluminum layer from the connection. Further advantages of such solution are alleviation of dicing problems caused by a thick layer of Aluminum, replacing copper foam structure which better work as a stress reliever, and increase the contact surface for the connection creating stronger joint.

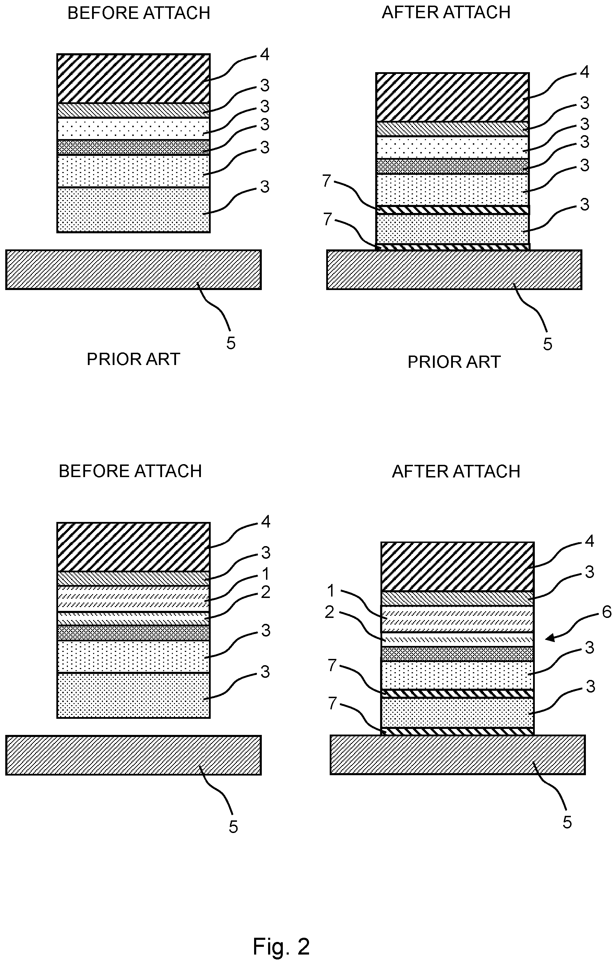

Figure 2 shows a similar comparison of a prior art method (on top) and the solution described by this document (on the bottom). However, the main difference is usage of Aluminum foam as a first layer 1 material and Nickel Vanadium as the second layer 2 material. The solution presented on Figure 2 is simple improvement of the prior art, replacing the solid Aluminum layer with Aluminum Foam, this allows to create the Nickel Vanadium and Aluminum first intermediate layer 6. Such modification has two main advantages namely less burr creation during dicing and better stress absorption caused by thermomechanical displacement.

The foam material in first example has thickness of 2000 nm and is heated together with the second layer 2 made of Tin which has 1000 nm. This allows for partial interconnection of the two layers creating first intermediate layer 7 wherein the liquified tin layer fills the non melted pores of the first layer 1, leaving a part of the first layer 1 not filled which allows the stress relaxation and prevents cracking of the die 4.

The metallic foam of the first layer 1 may have pore sizes of at least 10 µm and/or up to 100 µm. In some embodiments, the pore size may be up to 50 µm. In some embodiments, the pore size may be at least 10 µm and/or up to 30 µm. In some embodiments, the pore size may be 20 µm. The pore size may be chosen based on the size of the die 4 used. The porosity of the clip 8 may be at least 30% and/or up to 80%. The porosity of the foam may be chosen based on the size of the die 4 used. The connection in form of interpenetrated first and second increases the flexibility of the connection as compared to if the connection were formed from a continuous or solid material. The connection described also better secures die 4 to the lead frame 5. This is because second layer 2 only partially enters the pores of the first layer 1, which increases the contact area between the first layer 1 and second layer 2 as compared to if the connection were formed from a solid material.

The second layer 2 may be applied using electroplating or sputtering. These methods of application are advantageously more efficient that the conventional soldering method. This is because electroplating or sputtering of the second layer 2 can take place during assembly of other components onto the die 4 using the same method. The thickness of the first layer 1 maybe chosen based on, for example, the desired contact area between the die 4 and the lead frame 5. A first layer 1 is applied to the die 4. The first layer 1 may be applied using electroplating. The thickness of the first layer 1 may be chosen based on, for example, the size of the of the semiconductor device.

The temperature to which at least the second layer 2 is heated is determined by the material from which the second layer 2 and first layer 1 are made. In particular, the second layer 2 is heated to at least the melting temperature of the second layer 2 metallic but no more than meting point temperature of the first layer 1. The fist layer 1 metallic fam structure must not be damaged by the temperature. Where the second layer 2 is formed from tin, preferably pure tin, the temperature to which the second layer 2 is heated may be at least 232°C. The second layer 2 material must then have lower melting point temperature than the first layer 1 material.

While specific embodiments of the disclosure have been described above, it will be appreciated that the disclosure may be practiced otherwise than as described. The descriptions above are intended to be illustrative, not limiting. Thus, it will be apparent to one skilled in the art that modifications may be made to the disclosure as described without departing from the scope of the claims set out below.

Conductivity values expressed in percent (%) according to the IACS standard as100% IACS is equivalent to a conductivity of 58.108 mega siemens per meter (MS/m) at 20 °C or a resistivity of 1/58.108 ohm per meter for a wire one square millimeter in cross section. IACS % = (172.41/resistivity) where resistivity, ρ, (ro) is in micro-ohms per centimeter.

### LIST OF REFERENCE NUMERALS USED

- 1: First layer
- 2: Second layer
- 3: Third layer
- 4: Die
- 5: Lead frame
- 6: First Intermediate Layer
- 7: Second Intermediate Layer

## Claims

1. A semiconductor device comprising:
a die constituting the top layer of the semiconductor device;
a lead frame constituting the bottom layer of the semiconductor device;
a first layer located between the die and the lead frame;
a second layer located between the die and the lead frame being at least partially in surface contact with the first layer; wherein
the first layer is formed from a metallic foam and wherein the second layer is only partially interpenetrated with the first layer through the pores of the foam of the first layer, creating a first intermediate layer (6) between the first layer and second layer.

2. The semiconductor device according to claim 1, wherein the first layer is formed from copper, aluminum, gold, silver or their alloys.

3. The semiconductor device according to the claim 2, wherein it comprises at least one third layer located between the die and the lead frame, which comprises metals chosen from the group Titanium, Nickel, Vanad, Aluminum, Magnesium, Copper, Wolfram, Tungsten or its alloys.

4. The semiconductor device according to any or more of the preceding claims, wherein the die is made of Silicone.

5. The semiconductor device according to any or more of the preceding claims, wherein the lead frame has electrical conductivity in the range of 50 to 99% preferably 92%.

6. The semiconductor device according to any or more of the preceding claims, wherein the first layer have thickness of between 500 and 5000nm preferably 2000nm.

7. The semiconductor device according to any or more of the preceding claims, wherein the porosity of the metallic foam of the first layer is between 30% and 90% preferably 60%.

8. The semiconductor device according to any or more of the preceding claims, wherein the first layer comprises Copper, Aluminum or its alloys and the second layer comprises Tin, Silver.

9. The semiconductor device according to the claim 8, wherein the at least one third layer comprises Copper layer and Tin layer in surface contact with each other and wherein on top and bottom of the Tin layer there is second intermediate layer made of Copper and Tin alloys.

10. The semiconductor device according to any or more of the preceding claims, wherein the first layer comprises Copper or its alloys and the second layer comprises Tin or its alloys.

11. The semiconductor device according to the claim 10, wherein the first intermediate layer (6) comprises Copper and Tin alloys.

12. A method of manufacturing a semiconductor device according to any of the claims 1-11 comprising following steps:
a) providing a lead frame constituting the top layer of semiconductor device;
b) providing a die constituting the bottom layer of semiconductor device;
c) providing first layer between the lead frame and the die;
d) providing second layer between the lead frame and the die, being at least partially in surface contact with the first layer;
e) heating at least the second layer to the temperature of at least its melting point and lower then first layer melting point, allowing the liquefied second layer to interpenetrate only part of the first layer through the pores of the foam of the first layer and creating the first intermediate layer (6) between first layer and second layer.

13. The method of manufacturing according to claim 12, comprising an additional step of providing the at least one third layer between the lead frame and the die, being in surface contact with two of the layers: lead frame, die, first layer, second layer or different third layer.
